# EUROPEAN PATENT APPLICATION

(11) **EP 4 685 498 A1**
(43) Date of publication of application: **28.01.2026**
(21) Application number: 24190735.1
(22) Date of filing: 24.07.2024
(51) Int. Cl.: G01R 22/06, G01D 4/02, G01R 31/3828

(54) **BATTERY LIFE DETERMINATION FOR A METER**

(71) Applicant: Landis+Gyr GmbH, 90459 Nürnberg (DE)
(72) Inventor: HEINRICH, Matthias, 90762 Fürth (DE); BÄR, Siegfried, 90459 Nürnberg (DE)
(74) Representative: Marks & Clerk LLP

(57) **Abstract**

A meter (2) for measuring the consumption of a utility such as electricity, a fluid, gas, water, or heat, comprises a battery (6) and electronic circuitry (8), wherein the meter is configured so that the battery provides power to the electronic circuitry during a use period, and wherein the electronic circuitry is configured to, for each measurement instant of a plurality of measurement instants during the use period: capture or generate a time value corresponding to the measurement instant; perform one or more electrical measurements on the electronic circuitry at the measurement instant; determine a value of a current supplied by the battery at the measurement instant from the one or more electrical measurements; and determine a value of a voltage across the battery at the measurement instant from the one or more electrical measurements. The electronic circuitry is further configured to use the plurality of time values, the plurality of corresponding determined values of the current supplied by the battery, and the plurality of corresponding determined values of the voltage across the battery to determine an accumulated energy consumption value; determine a battery charge level based at least in part on the determined accumulated energy consumption value; and display an indication of the determined battery charge level.

## Description

### FIELD

The present disclosure relates to a meter for measuring the consumption of a utility such as electricity, a fluid, gas, water, or heat, and associated methods for determining a charge level of a battery of the meter.

### BACKGROUND

It is known to power a meter for measuring the consumption of a utility such as electricity, a fluid, gas, water, or heat, using a battery which is charged so as to store electronic energy. The battery discharges during operation of the meter and, unless the batter is replaced or recharged in a timely manner, the battery may run out of charge, resulting in a loss of power to the meter and inconvenience for a user of the meter. To avoid the battery running out of charge, it is known to estimate the battery charge level and to display an estimate of the battery charge level so that a user can determine when to replace or recharge the battery to avoid loss of power to the meter.

It is known to estimate the battery charge level based on the nominal storage capacity of the battery, a nominal rate of energy consumption of the meter, a nominal operating temperature, and the accumulated operating time of the meter when powered by the battery. However, the actual storage capacity of the battery may be different from the nominal storage capacity of the battery, the actual rate of energy consumption of the meter may be different from the nominal rate of energy consumption of the meter, and/or the actual operating temperature may deviate from the nominal operating temperature, resulting in a reduction in the accuracy of the estimate of the battery charge level determined using such known methods. Thus, use of such known methods for estimating the battery charge level may result in a display of an inaccurate estimate of the battery charge level to a user of the meter and could, in the worst case, result in a loss of power to the meter and inconvenience for the user if the user does not replace the battery before it runs out of charge.

To mitigate against the risk that the battery may run out of charge, it is known to estimate the battery charge level conservatively, for example by adjusting, by a predetermined factor or percentage, the estimate of the battery charge level calculated using the nominal storage capacity of the battery, the nominal rate of energy consumption of the meter, the nominal operating temperature, and the accumulated operating time of the meter when powered by the battery, and to display the adjusted battery charge level to the user. However, adjusting the estimate of the battery charge level and displaying the adjusted battery charge level to the user in this way may result in the user replacing the battery prematurely long before the battery has actually run out of charge resulting in only partial use of the battery and/or the user replacing or recharging the battery more frequently than is necessary.

### SUMMARY

According to an aspect of the present disclosure there is provided a meter for measuring the consumption of a utility, the meter comprising:
a battery; and
electronic circuitry,
wherein the meter is configured so that the battery provides power to the electronic circuitry during a use period, and
wherein the electronic circuitry is configured to, for each measurement instant of a plurality of measurement instants during the use period:
   capture or generate a time value corresponding to the measurement instant;
   perform one or more electrical measurements on the electronic circuitry at the measurement instant;
   determine a value of a current supplied by the battery at the measurement instant based on the one or more electrical measurements; and
   determine a value of a voltage across the battery at the measurement instant based on the one or more electrical measurements, and
wherein the electronic circuitry is further configured to:
   use the plurality of time values, the plurality of corresponding determined values of the current supplied by the battery, and the plurality of corresponding determined values of the voltage across the battery to determine an accumulated energy consumption value;
   determine a battery charge level based at least in part on the determined accumulated energy consumption value; and
   display an indication of the determined battery charge level.

Optionally, the utility comprises electricity, a fluid, gas, water, or heat.

Optionally, the electronic circuitry is configured to determine a difference between a nominal value of the initial energy stored in the battery and the determined accumulated energy consumption value and to determine the battery charge level based at least in part on the determined difference.

Optionally, the electronic circuitry is configured to determine the battery charge level to be equal to the determined difference.

Optionally, the electronic circuitry is configured to determine a ratio of the determined difference to the nominal value of the initial energy stored in the battery and to determine the battery charge level based at least in part on the determined ratio.

Optionally, the electronic circuitry is configured to determine the battery charge level to be equal to the determined ratio.

Optionally, the electronic circuitry is configured to select the plurality of measurement instants arbitrarily.

Optionally, the electronic circuitry is configured to select the plurality of measurement instants to be periodic in time or to have a regular frequency.

Optionally, the electronic circuitry is configured to select the plurality of measurement instants to be random in time.

Optionally, the electronic circuitry comprises a series resistor having a known resistance, wherein the series resistor is connected in series with the battery, and wherein the electronic circuitry is configured to measure a voltage across the series resistor and to determine the value of the current supplied by the battery at each measurement instant based on the measured voltage across the series resistor and the known resistance of the series resistor.

Optionally, the electronic circuitry comprises an ADC for converting the measured voltage across the series resistor into a measured value of the voltage across the series resistor.

Optionally, the electronic circuitry comprises a processing resource, wherein the processing resource is configured to determine the value of the current supplied by the battery at each measurement instant based on the measured value of the voltage across the series resistor and the known resistance of the series resistor at each measurement instant.

Optionally, the electronic circuitry comprises a memory for storing the known resistance of the series resistor.

Optionally, the memory is configured to store the measured value of the voltage across the series resistor at each measurement instant.

Optionally, the electronic circuitry comprises a series resistor having a known resistance, wherein the series resistor is connected in series with the battery, and an amplifier having a known variable gain or a controllable gain for amplifying the voltage across the series resistor and an ADC for converting the amplified voltage into a measured value of the amplified voltage.

Optionally, the electronic circuitry is configured to measure the amplified voltage across the series resistor and to determine the value of the current supplied by the battery at each measurement instant based on the measured amplified voltage across the series resistor, the corresponding known gain of the amplifier, and the known resistance of the series resistor.

Optionally, the electronic circuitry comprises a processing resource, wherein the processing resource is configured to determine the value of the current supplied by the battery at each measurement instant based on the measured value of the amplified voltage at each measurement instant, a corresponding known gain of the amplifier at each measurement instant, and the known resistance of the series resistor.

Optionally, the memory is configured to store the measured value of the amplified voltage at each measurement instant and the corresponding known gain of the amplifier at each measurement instant.

Optionally, the gain of the amplifier is controllable.

Optionally, the electronic circuitry comprises a voltage divider, wherein the voltage divider and the series resistor are connected in series across the battery, wherein the voltage divider includes a first resistor and a second resistor, wherein the first and second resistors are connected in series, and wherein the first and second resistors have known resistance values or a known ratio of resistance values.

Optionally, the electronic circuitry is configured to determine the value of the voltage across the battery at each measurement instant by:
measuring a value of the voltage across the first resistor;
determining a value of the voltage across the voltage divider based on the measured value of the voltage across the first resistor, and the known resistances, or the known ratio of the resistances, of the first and second resistors; and
adding the determined value of the voltage across the voltage divider to the measured value of the voltage across the series resistor.

Optionally, the electronic circuitry comprises an ADC for converting the voltage across the first resistor into the measured value of the voltage across the first resistor.

Optionally, the electronic circuitry comprises a processing resource, wherein the processing resource is configured to determine the value of the voltage across the battery by determining the value of the voltage across the voltage divider based on the measured value of the voltage across the first resistor and the known resistances, or the known ratio of the resistances, of the first and second resistors; and adding the determined value of the voltage across the voltage divider to the measured value of the voltage across the series resistor.

Optionally, the first resistor has a fixed resistance.

Optionally, the second resistor has a fixed resistance.

Optionally, the electronic circuitry comprises a memory for storing the known resistances, or the known ratio of the resistances, of the first and second resistors.

Optionally, the memory is configured to store the measured value of the voltage across the first resistor at each measurement instant.

Optionally, the first resistor has a variable resistance or a controllable resistance.

Optionally, the second resistor has a variable resistance or a controllable resistance.

Optionally, the electronic circuitry comprises a memory for storing the measured value of the voltage across the first resistor and the known resistances, or the known ratio of the resistances, of the first and second resistors corresponding to the measured value of the voltage across the first resistor at each measurement instant.

Optionally, the electronic circuitry is configured to determine the value of the voltage across the battery at each measurement instant by measuring a value of a voltage difference between the voltage across the battery and the voltage across the series resistor at each measurement instant, and adding the measured value of the voltage across the series resistor at each measurement instant to the measured voltage difference value at each measurement instant.

Optionally, the electronic circuitry comprises an ADC for converting the difference between the voltage across the battery and the voltage across the series resistor into the measured value of the voltage difference between the voltage across the battery and the voltage across the series resistor.

Optionally, the electronic circuitry comprises a processing resource, wherein the processing resource is configured to determine the value of the voltage across the battery at each measurement instant by adding the measured value of the voltage across the series resistor at each measurement instant to the measured voltage difference value at each measurement instant.

Optionally, the electronic circuitry comprises a memory for storing the measured voltage difference value at each measurement instant.

Optionally, the electronic circuitry comprises a processing resource which is configured to use the plurality of time values, the plurality of corresponding determined values of the current supplied by the battery, and the plurality of corresponding determined values of the voltage across the battery to determine the accumulated energy consumption value by:
setting an initial value of the accumulated energy consumption value to zero;
for the second and each subsequent measurement instant of the plurality of measurement instants during the use period:
   using the value of the current supplied by the battery at the measurement instant and the value of the current supplied by the battery at the preceding measurement instant to determine an average current during a measurement period between the preceding measurement instant and the measurement instant;
   using the value of the voltage across the battery at the measurement instant and the value of the voltage across the battery at the preceding measurement instant to determine an average voltage during the measurement period;
   using the time value corresponding to the measurement instant and the time value corresponding to the preceding measurement instant to determine a duration of the measurement period;
   multiplying the average current during the measurement period by the duration of the measurement period to determine the charge consumed during the measurement period;
   multiplying the charge consumed during the measurement period by the average voltage during the measurement period to determine the energy consumed during the measurement period; and
   incrementing the accumulated energy consumption value by the energy consumed during the measurement period.

Optionally, the electronic circuitry comprises a processing resource which is configured to use the plurality of time values, the plurality of corresponding determined values of the current supplied by the battery, and the plurality of corresponding determined values of the voltage across the battery to determine the accumulated energy consumption value by:
setting an initial value of the accumulated energy consumption value to zero;
for the second and each subsequent measurement instant of the plurality of measurement instants during the use period:
   multiplying the value of the current supplied by the battery at the measurement instant and the value the voltage across the battery at the measurement instant to determine a power value at the measurement instant;
   multiplying the value of the current supplied by the battery at the preceding measurement instant and the value the voltage across the battery at the preceding measurement instant to determine a power value at the preceding measurement instant;
   using the determined power value at the measurement instant and the determined power value at the preceding measurement instant to determine an average power value during a measurement period between preceding measurement instant and the measurement instant;
   using the time value corresponding to the measurement instant and the time value corresponding to the preceding measurement instant to determine a duration of the measurement period;
   multiplying the determined average power value during the measurement period by the determined duration of the measurement period to determine the energy consumed during the measurement period; and
   incrementing the accumulated energy consumption value by the energy consumed during the measurement period.

Optionally, the electronic circuitry comprises a memory for storing the nominal value of the initial energy stored in the battery.

Optionally, the memory is configured to store the plurality of time values, the plurality of corresponding determined values of the current supplied by the battery, and the plurality of corresponding determined values of the voltage across the battery.

Optionally, the memory is configured to store the accumulated energy consumption value.

Optionally, the electronic circuitry is configured to display an indication of the measured consumption of the utility together with the indication of the determined battery charge level.

Optionally, the electronic circuitry comprises a user interface for displaying the indication of the determined battery charge level.

Optionally, user interface is configured to display the indication of the measured consumption of the utility together with the indication of the determined battery charge level.

Optionally, the electronic circuitry comprises a utility consumption measurement arrangement for measuring the consumption of the utility.

According to an aspect of the present disclosure there is provided a method of providing an indication of a battery charge level of a battery of a meter for measuring the consumption of a utility, the method comprising:
for each measurement instant of a plurality of measurement instants during a use period when the battery is used to provide power to electronic circuitry of the meter:
   capturing or generating a time value corresponding to the measurement instant;
   performing one or more electrical measurements on the electronic circuitry at the measurement instant;
   determining a value of a current supplied by the battery at the measurement instant based on the one or more electrical measurements;
   determine a value of a voltage across the battery at the measurement instant based on the one or more electrical measurements, and
wherein the method further comprises:
   using the plurality of time values, the plurality of corresponding determined values of the current supplied by the battery, and the plurality of corresponding determined values of the voltage across the battery to determine an accumulated energy consumption value;
   determining a battery charge level based at least in part on the determined accumulated energy consumption value; and
   displaying an indication of the battery charge level.
Optionally, the utility comprises electricity, a fluid, gas, water, or heat.

Optionally, determining the battery charge level based at least in part on the determined accumulated energy consumption value comprises determining a difference between a nominal value of the initial energy stored in the battery and the determined accumulated energy consumption value and determining the battery charge level based at least in part on the determined difference.

Optionally, determining the battery charge level based at least in part on the determined accumulated energy consumption value comprises determining the battery charge level to be equal to the determined difference.

Optionally, determining the battery charge level based at least in part on the determined accumulated energy consumption value comprises determining a ratio of the determined difference to the nominal value of the initial energy stored in the battery, and determining the battery charge level based at least in part on the determined ratio.

Optionally, determining the battery charge level based at least in part on the determined accumulated energy consumption value comprises determining the battery charge level to be equal to the determined ratio.

Optionally, the method comprises selecting the plurality of measurement instants arbitrarily.

Optionally, the method comprises selecting the plurality of measurement instants to be periodic in time or to have a regular frequency.

Optionally, the method comprises selecting the plurality of measurement instants to be random in time.

Optionally, the electronic circuitry comprises a series resistor having a known resistance, wherein the series resistor is connected in series with the battery, and wherein the electronic circuitry is configured to measure the voltage across the series resistor. Optionally, determining the value of the current supplied by the battery at each measurement instant comprises measuring a value of a voltage across the series resistor, and determining the value of the current supplied by the battery based on the measured value of the voltage across the series resistor and the known resistance of the series resistor.

Optionally, the electronic circuitry comprises an amplifier for amplifying the voltage across the series resistor, and wherein the electronic circuitry is configured to measure the amplified voltage across the series resistor.

Optionally, determining the value of the current supplied by the battery at each measurement instant comprises measuring the amplified voltage across the series resistor and determining the value of the current supplied by the battery at each measurement instant based on the measured amplified voltage across the series resistor, a corresponding known gain of the amplifier, and the known resistance of the series resistor.

Optionally, the electronic circuitry comprises a voltage divider, wherein the voltage divider and the series resistor are connected in series across the battery, wherein the voltage divider includes a first resistor and a second resistor, wherein the first and second resistors are connected in series, and wherein the first and second resistors have known resistance values or a known ratio of resistance values.

Optionally, determining a value of a voltage across the battery at each measurement instant comprises:
measuring a value of the voltage across the first resistor;
determining a value of the voltage across the voltage divider based on the measured value of the voltage across the first resistor and the known resistances, or the known ratio of the resistances, of the first and second resistors; and
adding the determined value of the voltage across the voltage divider to the measured value of the voltage across the series resistor.

Optionally, determining the value of the voltage across the battery at each measurement instant comprises measuring a value of a voltage difference between the voltage across the battery and the voltage across the series resistor at each measurement instant, and adding the measured value of the voltage across the series resistor at each measurement instant to the measured voltage difference value at each measurement instant.

Optionally, using the plurality of time values, the plurality of corresponding determined values of the current supplied by the battery, and the plurality of corresponding determined values of the voltage across the battery to determine the accumulated energy consumption value comprises:
setting an initial value of the accumulated energy consumption value to zero;
for the second and each subsequent measurement instant of the plurality of measurement instants during the use period:
   using the value of the current supplied by the battery at the measurement instant and the value of the current supplied by the battery at the preceding measurement instant to determine an average current during a measurement period between the preceding measurement instant and the measurement instant;
   using the value of the voltage across the battery at the measurement instant and the value of the voltage across the battery at the preceding measurement instant to determine an average voltage during the measurement period;
   using the time value corresponding to the measurement instant and the time value corresponding to the preceding measurement instant to determine a duration of the measurement period;
   multiplying the average current during the measurement period by the duration of the measurement period to determine the charge consumed during the measurement period;
   multiplying the charge consumed during the measurement period by the average voltage during the measurement period to determine the energy consumed during the measurement period; and
   incrementing the accumulated energy consumption value by the energy consumed during the measurement period.

Optionally, using the plurality of time values, the plurality of corresponding determined values of the current supplied by the battery, and the plurality of corresponding determined values of the voltage across the battery to determine the accumulated energy consumption value comprises:
setting an initial value of the accumulated energy consumption value to zero;
for the second and each subsequent measurement instant of the plurality of measurement instants during the use period:
   multiplying the value of the current supplied by the battery at the measurement instant and the value the voltage across the battery at the measurement instant to determine a power value at the measurement instant;
   multiplying the value of the current supplied by the battery at the preceding measurement instant and the value the voltage across the battery at the preceding measurement instant to determine a power value at the preceding measurement instant;
   using the determined power value at the measurement instant and the determined power value at the preceding measurement instant to determine an average power value during a measurement period between preceding measurement instant and the measurement instant;
   using the time value corresponding to the measurement instant and the time value corresponding to the preceding measurement instant to determine a duration of the measurement period;
   multiplying the determined average power value during the measurement period by the determined duration of the measurement period to determine the energy consumed during the measurement period; and
   incrementing the accumulated energy consumption value by the energy consumed during the measurement period.

It should be understood that any one or more of the optional features of any one of the foregoing aspects of the present disclosure may be combined with any one or more of the other foregoing aspects of the present disclosure or the optional features of any one or more of the other foregoing aspects of the present disclosure.

### BRIEF DESCRIPTION OF THE DRAWINGS

A meter for measuring the consumption of a utility and associated methods for determining a charge level of a battery of the meter will now be described by way of non-limiting example only with reference to the drawings of which:
FIG. 1 is a circuit diagram of a meter for measuring the consumption of a utility, wherein the meter comprises a battery and electronic circuitry, and wherein the meter is configured so that the battery provides power to the electronic circuitry;
FIG. 2 is a schematic front view of the meter of FIG. 1 showing a user interface displaying an indication of a charge level of the battery;
FIG. 3A schematically illustrates measured values of the current supplied by the battery of the meter of FIG. 1 to the electronic circuitry of the meter of FIG. 1; and
FIG. 3B schematically illustrates measured values of the voltage across the battery of the meter of FIG. 1 as the battery supplies current to the electronic circuitry of the meter of FIG. 1.

### DETAILED DESCRIPTION OF THE DRAWINGS

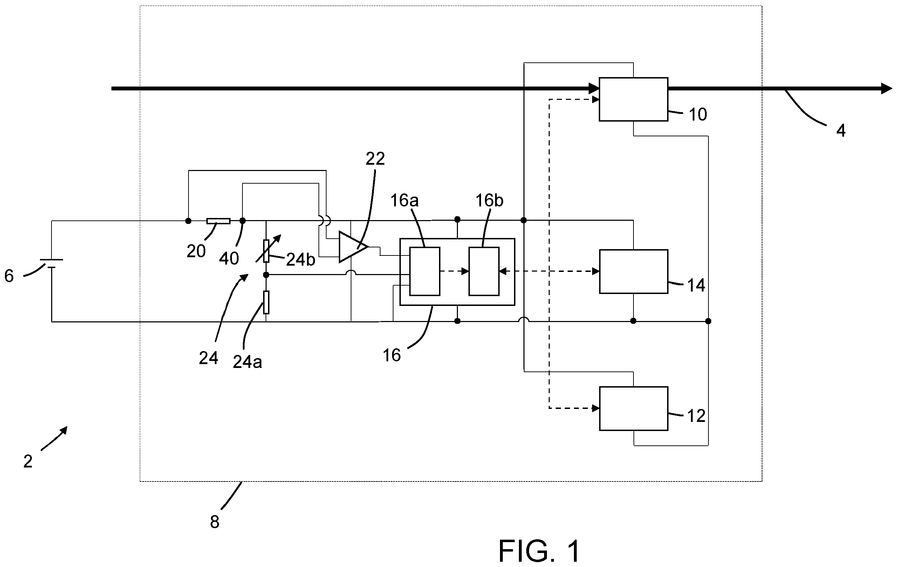

Referring initially to FIG. 1 there is shown a meter generally designated 2 for measuring the consumption of a utility such as electricity, a fluid, gas, water, or heat as the utility flows along a conduit 4 for consumption. The meter comprises a battery 6 and electronic circuitry generally designated 8, wherein the meter 2 is configured so that the battery 6 provides power to the electronic circuitry 8 during a use period.

The electronic circuitry 8 comprises a utility consumption measurement arrangement 10 for measuring a consumption of the utility as the utility flows along the conduit 4, a user interface 12, a memory 14, and a microprocessor 16. As illustrated by the dashed lines in FIG. 1, the utility consumption measurement arrangement 10, the user interface 12, and the memory 14, are configured for communication with the microprocessor 16.

The electronic circuitry 8 further comprises a series resistor 20 connected in series with the battery 6 and an amplifier 22 for amplifying a voltage across the series resistor 20. The series resistor 20 has a known resistance and the amplifier 22 has a known variable gain i.e. a controllable gain.

The electronic circuitry 8 further comprises a voltage divider generally designated 24, wherein the series resistor 20 and the voltage divider 24 are connected in series across the battery 6, and wherein the voltage divider 24 includes a first resistor 24a and a second resistor 24b connected in series with one another, wherein the first resistor 24a has a fixed resistance and the second resistor 24b has a variable resistance (i.e. a controllable resistance), and wherein the first and second resistors have known resistance values or a known ratio of resistance values.

The microprocessor 16 comprises a multi-channel ADC 16a for converting a voltage at the output of the amplifier 22 into a corresponding digital voltage value and for converting a voltage across the first resistor 24a of the voltage divider 24 into a corresponding digital voltage value.

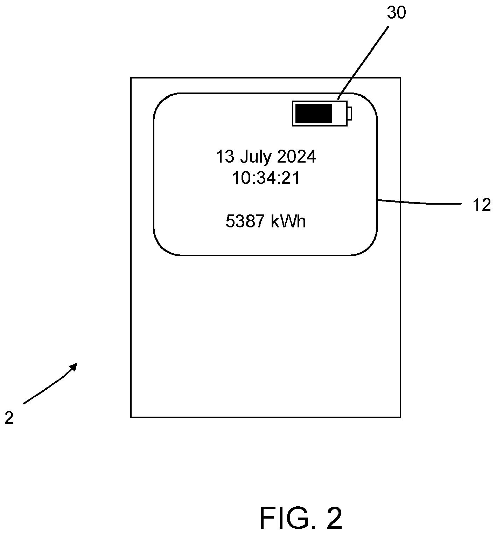

The microprocessor 16 further comprises a processing resource 16b which is configured to receive the digital voltage values from the multi-channel ADC 16a. As will be described in more detail below, the processing resource 16b is configured to process the received digital voltage values to determine a value for the battery charge level and to display an indication 30 of the determined battery charge level via the user interface 12 as shown in FIG. 2.

The memory 14 stores the known resistance of the series resistor 20. The memory 14 also stores a nominal value of the initial energy stored in the battery.

In use, for each measurement instant of a plurality of measurement instants during a use period during which the battery 6 provides power to the electronic circuitry 8 (i.e. during which the battery 6 is under the load of the electronic circuitry 8), the electronic circuitry 8:
captures or generates a time value corresponding to the measurement instant;
performs one or more electrical measurements on the electronic circuitry 8 at the measurement instant;
determines a value of a current supplied by the battery 6 at the measurement instant based on the one or more electrical measurements; and
determines a value of a voltage across the battery 6 at the measurement instant based on the one or more electrical measurements.

The processing resource 16b uses the plurality of time values, the plurality of corresponding determined values of the current supplied by the battery 6, and the plurality of corresponding determined values of the voltage across the battery 6 to determine an accumulated energy consumption value. The processing resource 16b then determines a difference between a nominal value of the initial energy stored in the battery 6 and the accumulated energy consumption value by subtracting the accumulated energy consumption value from the nominal value of the initial energy stored in the battery 6, determines a ratio of the determined difference to the nominal value of the initial energy stored in the battery 6 by dividing the determined difference by the nominal value of the initial energy stored in the battery 6, and determines a battery charge level to be equal to the determined ratio. As shown in FIG. 2, the processing resource 16b then displays an indication of the determined battery charge level such as a graphical or symbolic representation 30 of the determined battery charge level together with an indication of the date and time and an indication of the measured consumption of the utility via the user interface 12.

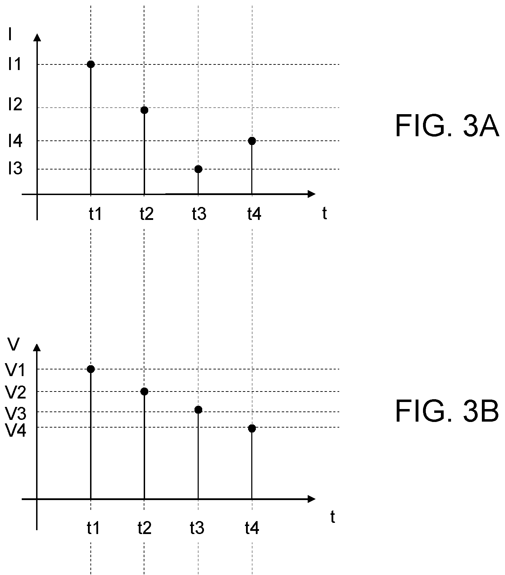

The multi-channel ADC 16a converts the voltage at the output of the amplifier 22 into a corresponding voltage value at each measurement instant. The processing resource 16b determines the value of the current supplied by the battery at each measurement instant based on the measured value of the amplified voltage at each measurement instant, the corresponding known gain of the amplifier 22 at each measurement instant, and the known resistance of the series resistor 20 stored in the memory 14. This may result in a plurality of determined values I1, I2, I3 and I4 of the current supplied by the battery 6 at a plurality of measurement instants t1, t2, t3 and t4 respectively as shown in FIG. 3A.

The multi-channel ADC 16a converts the voltage across the first resistor 24a of the voltage divider 24 into a corresponding voltage value at each measurement instant. The processing resource 16b determines the value of the voltage across the voltage divider 24 at each measurement instant from the measured value of the voltage across the first resistor 24a at the measurement instant and the known resistances, or the known ratio of the resistances, of the first and second resistors 24a, 24b at the measurement instant, and determines the value of the voltage across the battery 6 at each measurement instant by adding the determined value of the voltage across the voltage divider 24 to the measured value of the voltage across the series resistor 20. This may result in a plurality of determined values V1, V2, V3 and V4 of the voltage across the battery 6 at the plurality of measurement instants t1, t2, t3 and t4 respectively as shown in FIG. 3B.

The processing resource 16b then uses the plurality of time values t1, t2, t3, t4, the plurality of corresponding determined values 11, 12, 13, I4 of the current supplied by the battery 6, and the plurality of corresponding determined values V1, V2, V3, V4 of the voltage across the battery 6 to determine an accumulated energy consumption value by:
setting an initial value of the accumulated energy consumption value to zero;
for the second t2 and each subsequent measurement instant t3, t4 of the plurality of measurement instants during the use period:
   using the value of the current supplied by the battery 6 at the measurement instant and the value of the current supplied by the battery 6 at the preceding measurement instant to determine an average current during a measurement period between the preceding measurement instant and the measurement instant;
   using the value of the voltage across the battery 6 at the measurement instant and the value of the voltage across the battery 6 at the preceding measurement instant to determine an average voltage during the measurement period;
   using the time value corresponding to the measurement instant and the time value corresponding to the preceding measurement instant to determine a duration of the measurement period;
   multiplying the average current during the measurement period by the duration of the measurement period to determine the charge consumed during the measurement period;
   multiplying the charge consumed during the measurement period by the average voltage during the measurement period to determine the energy consumed during the measurement period; and
   incrementing the accumulated energy consumption value by the energy consumed during the measurement period.

One of skill in the art will understand that by determining the current supplied by the battery 6 from one or more electrical measurements performed on the electronic circuitry at the measurement instant and by determining the voltage across the battery 6 from one or more electrical measurements performed on the electronic circuitry at the measurement instant during the use period during which the battery 6 provides power to the electronic circuitry 8 as described above with reference to FIGS. 1 to 3, the accumulated energy consumption value may be determined with more accuracy than known methods for estimating the accumulated energy consumption value which are based on a nominal storage capacity of the battery, a nominal rate of energy consumption of a meter, a nominal operating temperature, and the accumulated operating time of the meter when powered by the battery. Consequently, displaying an indication of the battery charge level determined using the accumulated energy consumption value determined from one or more electrical measurements performed on the electronic circuitry during the use period as described above with reference to FIGS. 1 to 3 may result in a more accurate indication of the battery charge level. This may mitigate against the risk that the battery 6 may run out of charge before the battery is replaced whilst also reducing the likelihood that a user of the meter 2 will replace the battery prematurely and/or reducing the frequency with which a user replaces or recharges the battery 6.

Use of an amplifier 22 having a known variable gain may improve the dynamic range of the measurement of the voltage across the series resistor 20 and may therefore improve the dynamic range of the method for determining the current supplied by the battery 6. Use of a voltage divider 24 which includes a variable resistor 24b may improve the dynamic range of the measurement of the voltage across the voltage divider 24 and may therefore improve the dynamic range of the method for determining the voltage across the battery 6.

One of ordinary skill in the art will also understand that various modifications are possible to the meter, the mobile electronic device and the associated methods described above. For example, the electronic circuitry 8 may be configured to determine the battery charge level based at least in part on the determined accumulated energy consumption value using a method other than the method described above. The electronic circuitry 8 may be configured to determine the difference between the nominal value of the initial energy stored in the battery 6 and the determined accumulated energy consumption value and to determine the battery charge level based at least in part on the determined difference. For example, the electronic circuitry 8 may be configured to determine the battery charge level to be equal to the determined difference.

Rather than using the plurality of time values, the plurality of corresponding determined values of the current supplied by the battery 6, and the plurality of corresponding determined values of the voltage across the battery 6 to determine an accumulated energy consumption value as described above, the processing resource 16b may use the plurality of time values, the plurality of corresponding determined values of the current supplied by the battery 6, and the plurality of corresponding determined values of the voltage across the battery 6 to determine an accumulated energy consumption value by:
setting an initial value of the accumulated energy consumption value to zero;
for the second and each subsequent measurement instant of the plurality of measurement instants during the use period:
   multiplying the value of the current supplied by the battery 6 at the measurement instant and the value the voltage across the battery 6 at the measurement instant to determine a power value at the measurement instant;
   multiplying the value of the current supplied by the battery 6 at the preceding measurement instant and the value the voltage across the battery 6 at the preceding measurement instant to determine a power value at the preceding measurement instant;
   using the determined power value at the measurement instant and the determined power value at the preceding measurement instant to determine an average power value during a measurement period between preceding measurement instant and the measurement instant;
   using the time value corresponding to the measurement instant and the time value corresponding to the preceding measurement instant to determine a duration of the measurement period;
   multiplying the determined average power value during the measurement period by the determined duration of the measurement period to determine the energy consumed during the measurement period; and
   incrementing the accumulated energy consumption value by the energy consumed during the measurement period.

The processing resource 16b may be configured to select the plurality of measurement instants arbitrarily. For example, the processing resource 16b may be configured to select the plurality of measurement instants to be periodic in time or to have a regular frequency. The processing resource 16b may be configured to select the plurality of measurement instants to be random in time.

The memory 14 may be configured to store the measured value of the voltage across the series resistor 20 at each measurement instant.

The memory 14 may be configured to store the measured value of the amplified voltage and the corresponding known gain of the amplifier 22 at each measurement instant.

The memory 14 may be configured to store the measured value of the voltage across the first resistor 24a of the voltage divider 24 and the known resistances, or the known ratio of the resistances, of the first and second resistors 24a, 24b of the voltage divider 24 at each measurement instant.

The controllable gain of the variable gain amplifier 22 may be greater than one. The controllable gain of the variable gain amplifier 22 may be equal, or substantially equal, to one. When the controllable gain of the variable gain amplifier 22 is equal, or substantially equal, to one, the variable gain amplifier 22 may act as a voltage buffer so that the voltage value measured by the ADC 16a is equal to or substantially equal to the voltage across the series resistor 20. The controllable gain of the variable gain amplifier 22 may be less than one.

Rather than using an amplifier 22 having a known variable gain to amplify the voltage across the series resistor 20, an amplifier having a known fixed gain may be used to amplify the voltage across the series resistor 20.

The variable gain amplifier 22 may be omitted and the voltage across the series resistor 20 measured directly without amplification.

The voltage divider 24 may be configured so that a resistance value of the known variable resistor 24b is controllable from a minimum resistance value to a maximum resistance value. The minimum resistance value may be equal to zero or substantially equal to zero.

The electronic circuitry may comprise a series resistor and a voltage divider, wherein the voltage divider and the series resistor are connected in series across the battery, wherein the voltage divider includes a first resistor and a second resistor, wherein the first and second resistors are connected in series, wherein the first and second resistors have known resistance values or a known ratio of resistance values, wherein the first resistor has a fixed resistance or a variable or controllable resistance, and the second resistor has a fixed resistance or a variable or controllable resistance.

The electronic circuitry may be configured to determine the value of the voltage across the battery at each measurement instant by:
measuring a value of the voltage across the first resistor;
determining a value of the voltage across the voltage divider based on the measured value of the voltage across the first resistor and the known resistances, or the known ratio of the resistances, of the first and second resistors; and
adding the determined value of the voltage across the voltage divider to the measured value of the voltage across the series resistor.

The electronic circuitry may comprise a memory for storing the known resistances, or the known ratio of the resistances, of the first and second resistor.

The memory may be configured to store the measured value of the voltage across the first resistor at each measurement instant.

Rather than measuring the voltage across the first resistor 24a of the voltage divider 24 and determining the voltage across the voltage divider 24 from the voltage measured across the first resistor 24a and the known resistances, or the known ratio of the resistances, of the first and second resistors 24a, 24b at each measurement instant, the electronic circuitry 8 may be configured so that the multi-channel ADC 16a measures a value of the difference between the voltage across the battery 6 and the voltage across the series resistor 20 directly at each measurement instant i.e. the electronic circuitry 8 may be configured so that the multi-channel ADC 16a measures a value of the voltage at node 40 directly at each measurement instant. The processing resource 16b may then be configured to measure the value of the voltage across the battery 6 at each measurement instant by measuring a value of the voltage difference between the voltage across the battery 6 and the voltage across the series resistor 20 at each measurement instant, and adding the measured value of the voltage across the series resistor 20 at each measurement instant to the measured voltage difference value at each measurement instant. When the electronic circuitry 8 is configured so that the multi-channel ADC 16a measures a value of the difference between the voltage across the battery 6 and the voltage across the series resistor 20 at each measurement instant in this way, the voltage divider 24 may be omitted.

The user interface may be configured to provide an indication of the battery charge level of any kind such as visual or audio indication of the battery charge level of any kind. Rather than providing a graphical indication of the battery charge level, the user interface may be configured to provide a text-based or a numerical indication of the battery charge level.

Although the meter 2 of FIG. 1 is described as comprising a microprocessor 16 which includes a multi-channel ADC 16a and a processing resource 16b, other embodiments may include a multi-channel ADC and a processing resource which are provided separately i.e. which do not form part of a microprocessor.

Although a meter and associated methods have been described in terms of specific embodiments as set forth above, it should be understood that these embodiments are illustrative only and that the invention is not limited to those embodiments. Those skilled in the art will be able to make modifications and alternatives to the described embodiments in view of the disclosure which are contemplated as falling within the scope of the appended claims. Each feature disclosed or illustrated herein may be incorporated in any embodiment, whether alone or in any appropriate combination with any other feature disclosed or illustrated herein. In particular, one of ordinary skill in the art will understand that one or more of the features of the embodiments of the present disclosure described above with reference to the drawings may produce effects or provide advantages when used in isolation from one or more of the other features of the embodiments of the present disclosure and that different combinations of the features are possible other than the specific combinations of the features of the embodiments of the present disclosure described above.

The skilled person will understand that in the preceding description and appended claims, positional terms such as 'above', `along', 'side', etc. are made with reference to the accompanying drawings. These terms are used for ease of reference but are not intended to be of limiting nature. These terms are therefore to be understood as referring to an object when in an orientation as shown in the accompanying drawings.

Use of the term "comprising" when used in relation to a feature of an embodiment of the present disclosure does not exclude other features or steps. Use of the term "a" or "an" when used in relation to a feature of an embodiment of the present disclosure does not exclude the possibility that the embodiment may include a plurality of such features.

The use of reference signs in the claims should not be construed as limiting the scope of the claims.

## Claims

1. A meter for measuring the consumption of a utility such as electricity, a fluid, gas, water, or heat, the meter comprising:
a battery; and
electronic circuitry,
wherein the meter is configured so that the battery provides power to the electronic circuitry during a use period, and
wherein the electronic circuitry is configured to, for each measurement instant of a plurality of measurement instants during the use period:
capture or generate a time value corresponding to the measurement instant;
perform one or more electrical measurements on the electronic circuitry at the measurement instant;
determine a value of a current supplied by the battery at the measurement instant based on the one or more electrical measurements; and
determine a value of a voltage across the battery at the measurement instant based on the one or more electrical measurements, and
wherein the electronic circuitry is further configured to:
use the plurality of time values, the plurality of corresponding determined values of the current supplied by the battery, and the plurality of corresponding determined values of the voltage across the battery to determine an accumulated energy consumption value;
determine a battery charge level based at least in part on the determined accumulated energy consumption value; and
display an indication of the determined battery charge level.

2. The meter as claimed in claim 1, wherein the electronic circuitry is configured to determine a difference between a nominal value of the initial energy stored in the battery and the determined accumulated energy consumption value and to determine the battery charge level based at least in part on the determined difference, for example to determine the battery charge level to be equal to the determined difference, and optionally
wherein the electronic circuitry is configured to determine a ratio of the determined difference to the nominal value of the initial energy stored in the battery and to determine the battery charge level based at least in part on the determined ratio, for example to determine the battery charge level to be equal to the determined ratio.

3. The meter as claimed in claim 1 or 2, wherein the electronic circuitry is configured to select the plurality of measurement instants arbitrarily, to select the plurality of measurement instants to be periodic in time or to have a regular frequency, or to select the plurality of measurement instants to be random in time.

4. The meter as claimed in any preceding claim, wherein the electronic circuitry comprises a series resistor having a known resistance, wherein the series resistor is connected in series with the battery, and wherein the electronic circuitry is configured to measure a voltage across the series resistor and to determine the value of the current supplied by the battery at each measurement instant based on the measured voltage across the series resistor and the known resistance of the series resistor.

5. The meter as claimed in claim 4, wherein the electronic circuitry comprises an ADC and a processing resource, wherein the ADC is configured to convert the measured voltage across the series resistor into a measured value of the voltage across the series resistor, and wherein the processing resource is configured to determine the value of the current supplied by the battery at each measurement instant based on the known resistance of the series resistor and the measured value of the voltage across the series resistor at each measurement instant.

6. The meter as claimed in any one of claims 1 to 3, wherein the electronic circuitry comprises a series resistor having a known resistance, wherein the series resistor is connected in series with the battery, and wherein the electronic circuitry comprises an amplifier having a known gain for amplifying the voltage across the series resistor, an ADC for converting the amplified voltage into a measured value of the amplified voltage, and a processing resource, wherein the processing resource is configured to determine the value of the current supplied by the battery at each measurement instant based on the measured value of the amplified voltage at each measurement instant, the corresponding known gain of the amplifier at each measurement instant, and the known resistance of the series resistor, and optionally, wherein the known gain of the amplifier is controllable.

7. The meter as claimed in any one of claims 4 to 6, wherein the electronic circuitry comprises a voltage divider,
wherein the voltage divider and the series resistor are connected in series across the battery,
wherein the voltage divider includes first and second resistors, wherein the first and second resistors are connected in series, and wherein the first and second resistors have known resistance values or a known ratio of resistance values, and
wherein the electronic circuitry is configured to determine the value of the voltage across the battery at each measurement instant by:
measuring a value of the voltage across the first resistor;
determining a value of the voltage across the voltage divider based on the measured value of the voltage across the first resistor and the known resistances, or the known ratio of the resistances, of the first and second resistors; and
adding the determined value of the voltage across the voltage divider to the measured value of the voltage across the series resistor.

8. The meter as claimed in claim 7, wherein the electronic circuitry comprises an ADC, and a processing resource, wherein the ADC is configured to convert the voltage across the first resistor into the determined value of the voltage at the output of the voltage divider, and wherein the processing resource is configured to determine the value of the voltage across the voltage divider at each measurement instant from the measured value of the voltage across the first resistor and from the known resistances, or the known ratio of the resistances, of the first and second resistors, and to determine the value of the voltage across the battery at each measurement instant by adding the determined value of the voltage across the voltage divider to the measured value of the voltage across the series resistor.

9. The meter as claimed in any one of claims 4 to 8, wherein the electronic circuitry is configured to determine the value of the voltage across the battery at each measurement instant by measuring a value of a voltage difference between the voltage across the battery and the voltage across the series resistor at each measurement instant, and adding the measured value of the voltage across the series resistor at each measurement instant to the measured voltage difference value at each measurement instant.

10. The meter as claimed in claim 9, wherein the electronic circuitry comprises an ADC, and a processing resource, wherein the ADC is configured to convert the difference between the voltage across the battery and the voltage across the series resistor into the measured value of the voltage difference between the voltage across the battery and the voltage across the series resistor, and wherein the processing resource is configured to determine the value of the voltage across the battery at each measurement instant by adding the measured value of the voltage across the series resistor at each measurement instant to the measured value of the voltage difference between the voltage across the battery and the voltage across the series resistor at each measurement instant.

11. The meter as claimed in any preceding claim, wherein the electronic circuitry comprises a processing resource which is configured to use the plurality of time values, the plurality of corresponding determined values of the current supplied by the battery, and the plurality of corresponding determined values of the voltage across the battery to determine the accumulated energy consumption value by:
setting an initial value of the accumulated energy consumption value to zero;
for the second and each subsequent measurement instant of the plurality of measurement instants during the use period:
using the value of the current supplied by the battery at the measurement instant and the value of the current supplied by the battery at the preceding measurement instant to determine an average current during a measurement period between the preceding measurement instant and the measurement instant;
using the value of the voltage across the battery at the measurement instant and the value of the voltage across the battery at the preceding measurement instant to determine an average voltage during the measurement period;
using the time value corresponding to the measurement instant and the time value corresponding to the preceding measurement instant to determine a duration of the measurement period;
multiplying the average current during the measurement period by the duration of the measurement period to determine the charge consumed during the measurement period;
multiplying the charge consumed during the measurement period by the average voltage during the measurement period to determine the energy consumed during the measurement period; and
incrementing the accumulated energy consumption value by the energy consumed during the measurement period.

12. The meter as claimed in any one of claims 1 to 10, wherein the electronic circuitry comprises a processing resource which is configured to use the plurality of time values, the plurality of corresponding determined values of the current supplied by the battery, and the plurality of corresponding determined values of the voltage across the battery to determine the accumulated energy consumption value by:
setting an initial value of the accumulated energy consumption value to zero;
for the second and each subsequent measurement instant of the plurality of measurement instants during the use period:
multiplying the value of the current supplied by the battery at the measurement instant and the value the voltage across the battery at the measurement instant to determine a power value at the measurement instant;
multiplying the value of the current supplied by the battery at the preceding measurement instant and the value the voltage across the battery at the preceding measurement instant to determine a power value at the preceding measurement instant;
using the determined power value at the measurement instant and the determined power value at the preceding measurement instant to determine an average power value during a measurement period between preceding measurement instant and the measurement instant;
using the time value corresponding to the measurement instant and the time value corresponding to the preceding measurement instant to determine a duration of the measurement period;
multiplying the determined average power value during the measurement period by the determined duration of the measurement period to determine the energy consumed during the measurement period; and
incrementing the accumulated energy consumption value by the energy consumed during the measurement period.

13. A method of providing an indication of a battery charge level of a battery of a meter for measuring the consumption of a utility such as electricity, a fluid, gas, water, or heat, the method comprising:
for each measurement instant of a plurality of measurement instants during a use period when the battery is used to provide power to electronic circuitry of the meter:
capturing or generating a time value corresponding to the measurement instant;
performing one or more electrical measurements on the electronic circuitry at the measurement instant;
determining a value of a current supplied by the battery at the measurement instant based on the one or more electrical measurements;
determining a value of a voltage across the battery at the measurement instant based on the one or more electrical measurements, and
wherein the method further comprises:
using the plurality of time values, the plurality of corresponding determined values of the current supplied by the battery, and the plurality of corresponding determined values of the voltage across the battery to determine an accumulated energy consumption value;
determining a battery charge level based at least in part on the determined accumulated energy consumption value; and
displaying an indication of the battery charge level.

14. The method as claimed in claim 13, wherein determining the battery charge level based at least in part on the determined accumulated energy consumption value comprises determining a difference between a nominal value of the initial energy stored in the battery and the determined accumulated energy consumption value and determining the battery charge level based at least in part on the determined difference, for example determining the battery charge level to be equal to the determined difference, and optionally
wherein determining the battery charge level based at least in part on the determined accumulated energy consumption value comprises determining a ratio of the determined difference to the nominal value of the initial energy stored in the battery, and determining the battery charge level based at least in part on the determined ratio, for example determining the battery charge level to be equal to the determined ratio.

15. The method as claimed in claim 13 or 14, wherein using the plurality of time values, the plurality of corresponding determined values of the current supplied by the battery, and the plurality of corresponding determined values of the voltage across the battery to determine the accumulated energy consumption value comprises:
setting an initial value of the accumulated energy consumption value to zero;
for the second and each subsequent measurement instant of the plurality of measurement instants during the use period:
using the value of the current supplied by the battery at the measurement instant and the value of the current supplied by the battery at the preceding measurement instant to determine an average current during a measurement period between the preceding measurement instant and the measurement instant;
using the value of the voltage across the battery at the measurement instant and the value of the voltage across the battery at the preceding measurement instant to determine an average voltage during the measurement period;
using the time value corresponding to the measurement instant and the time value corresponding to the preceding measurement instant to determine a duration of the measurement period;
multiplying the average current during the measurement period by the duration of the measurement period to determine the charge consumed during the measurement period;
multiplying the charge consumed during the measurement period by the average voltage during the measurement period to determine the energy consumed during the measurement period; and
incrementing the accumulated energy consumption value by the energy consumed during the measurement period; or
wherein using the plurality of time values, the plurality of corresponding determined values of the current supplied by the battery, and the plurality of corresponding determined values of the voltage across the battery to determine the accumulated energy consumption value comprises:
setting an initial value of the accumulated energy consumption value to zero;
for the second and each subsequent measurement instant of the plurality of measurement instants during the use period:
multiplying the value of the current supplied by the battery at the measurement instant and the value the voltage across the battery at the measurement instant to determine a power value at the measurement instant;
multiplying the value of the current supplied by the battery at the preceding measurement instant and the value the voltage across the battery at the preceding measurement instant to determine a power value at the preceding measurement instant;
using the determined power value at the measurement instant and the determined power value at the preceding measurement instant to determine an average power value during a measurement period between preceding measurement instant and the measurement instant;
using the time value corresponding to the measurement instant and the time value corresponding to the preceding measurement instant to determine a duration of the measurement period;
multiplying the determined average power value during the measurement period by the determined duration of the measurement period to determine the energy consumed during the measurement period; and
incrementing the accumulated energy consumption value by the energy consumed during the measurement period.
